(19) Europäisches Patentamt / European Patent Office / Office européen des brevets

(11) **EP 2 746 798 B1**

(12) **FASCICULE DE BREVET EUROPEEN**

(45) Date de publication et mention
de la délivrance du brevet:
**30.03.2016 Bulletin 2016/13**

(51) Int Cl.:
***H02S 50/10*** *(2014.01)*     ***G01R 31/12*** *(2006.01)*
***G01R 31/08*** *(2006.01)*

(21) Numéro de dépôt: **13198072.4**

(22) Date de dépôt: **18.12.2013**

(54) **Système et procédé de détection et de localisation de défaut d'isolation d'un générateur solaire d'engin spatial**

Vorrichtung und Verfahren zur Erkennung und Lokalisierung eines Isolationsfehlers in einem Solargenerator eines Raumfahrzeugs

System and method for the detection and the localisation of an isolation fault of a solar generator of a space craft

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2012 FR 1203570**

(43) Date de publication de la demande:
**25.06.2014 Bulletin 2014/26**

(73) Titulaires:
• **Airbus Defence and Space SAS**
  **78130 Les Mureaux (FR)**
• **Centre National d'Etudes Spatiales (CNES)**
  **75001 Paris (FR)**

(72) Inventeurs:
• **Carla, Emmanuelle**
  **31400 Toulouse (FR)**
• **Barde, Henri**
  **2200 AG Noordwijk (NL)**

(74) Mandataire: **Ipside**
  **6, Impasse Michel Labrousse**
  **31100 Toulouse (FR)**

(56) Documents cités:
**EP-A1- 1 265 076**     **EP-A2- 2 146 518**
**WO-A2-2012/100263**     **DE-A1-102011 007 222**
**JP-A- 2012 119 382**     **US-A1- 2012 160 297**
**US-A1- 2012 274 138**

• **RIVERA J C ET AL: "Protoflight photovoltaic power module system-level tests in the space power facility", 19890806; 19890806 - 19890811, 6 août 1989 (1989-08-06), pages 2601-2615, XP010089953,**

**Description**

**DOMAINE TECHNIQUE**

La présente invention appartient au domaine de la génération d'énergie électrique à bord d'un engin spatial, tel qu'un satellite en orbite autour d'un corps céleste. Plus particulièrement, la présente invention concerne un système et un procédé de détection et de localisation de défaut d'isolation d'un générateur solaire d'engin spatial.

**ÉTAT DE LA TECHNIQUE**

Les engins spatiaux, en particulier les satellites en orbite autour d'un corps céleste, comportent généralement un ou plusieurs générateurs solaires afin de générer l'énergie électrique nécessaire à leur fonctionnement.

Généralement, un générateur solaire d'un satellite se présente sous la forme d'un appendice dudit satellite, sensiblement en forme de panneau. Un tel générateur solaire est de manière générale composé de plusieurs volets. Chaque volet porte plusieurs cellules solaires reliées à un réseau de distribution électrique qui achemine l'énergie électrique, fournie par lesdites cellules solaires, vers des accumulateurs électriques et vers différents équipements électriques dudit satellite.

Les cellules solaires sont en outre isolées électriquement des volets, et lesdits volets sont reliés à une ligne de mise à la masse, le plus souvent par l'intermédiaire d'une charge, tel qu'une simple résistance, afin d'assurer une protection du générateur solaire contre les décharges électrostatiques.

De nos jours il a été constaté des anomalies de fonctionnement de générateurs solaires de satellites en orbite terrestre. En particulier, il est connu que des débris spatiaux, tels que des météorites, peuvent percuter les générateurs solaires et entraîner des défauts d'isolation de certaines cellules solaires, qui se trouvent alors reliées électriquement aux volets, et donc à la masse par l'intermédiaire de la ligne de mise à la masse.

De tels défauts d'isolation peuvent être détectés en mesurant le courant circulant dans la ligne de mise à la masse.

Juan C. Rivera et Luke A. Kirch décrivent dans le document "Photoflight Photovoltaic Power Module System-Level in the Space Power Facility", National Aeronautics and Space Administration Lewis Research Center, Cleveland, Ohio, 1989, différents procédés de test d'un générateur solaire d'engin spatial.

La demande des brevets publiée WO 2012/100263 A décrit un procédé de détection des défauts pour un générateur solaire basé sur la détections des différences entre des courants mesurés pour des modules photovoltaïques connectés en série.

Les demandes des brevets publiées DE 102011 007 222 A et EP 1 265 076 A décrivent des systèmes pour surveiller la resistance d'isolation d'un générateur solaire. Les systèmes évaluent des potentiels mesurés sur des résisteurs connectés symétriquement aux lignes électriques du générateur solaire.

Toutefois, il n'est pas connu de solution permettant de localiser de tels défauts d'isolation sur un générateur solaire, c'est-à-dire une solution permettant d'identifier notamment sur quel volet se trouve la cellule solaire qui présente un défaut d'isolation.

**EXPOSÉ DE L'INVENTION**

La présente invention a pour objectif de remédier à tout ou partie des limitations des solutions de l'art antérieur, notamment celles exposées ci-avant, en proposant une solution qui permette de détecter et de localiser un défaut d'isolation d'un générateur solaire d'un véhicule spatial.

En outre, la présente invention a également pour objectif de proposer une solution qui nécessite d'apporter peu de modifications aux agencements actuels de générateurs solaires.

En particulier, les générateurs solaires sont le plus souvent montés mobiles en rotation, au moyen de mécanismes d'entraînement, dit « MEGS » (« Mécanisme d'Entraînement du Générateur Solaire »), par lesquels transitent le réseau de distribution électrique et la ligne de mise à la masse. Les MEGS sont des dispositifs généralement complexes, comportant notamment des joints tournants, et offrent donc peu d'espace pour passer d'autres câbles. Par conséquent, la présente invention vise à proposer une solution qui nécessite le passage, dans les MEGS, de peu ou pas de câbles supplémentaires par rapport aux générateurs solaires actuels.

A cet effet, et selon un premier aspect, la présente invention concerne un système de détection et de localisation de défaut d'isolation d'un générateur solaire d'engin spatial, selon la revendication 1. Le générateur solaire comporte plusieurs volets, chaque volet portant au moins une cellule solaire reliée à un réseau de distribution électrique et isolée électriquement dudit volet. En outre, chaque volet est relié, par une première charge et par une seconde charge, à respectivement une première ligne électrique et une seconde ligne électrique, distincte de la première ligne électrique. Le rapport entre les impédances de la première charge et de la seconde charge d'un volet étant désigné par « rapport d'impédances » dudit volet, le générateur solaire comporte au moins deux volets présentant des rapports d'impédances respectifs différents. Par ailleurs, ledit système comporte en outre :

- des moyens adaptés à évaluer des courants circulant dans respectivement la première ligne électrique et la seconde ligne électrique,
- des moyens adaptés à détecter et à localiser un défaut d'isolation du générateur solaire en fonction des évaluations des courants circulant dans respectivement la première ligne électrique et la seconde ligne électrique.

Par « évaluation du courant », on entend une mesure ou un calcul de tout paramètre représentatif du courant considéré. Ledit paramètre est par exemple une tension ou un courant. Par exemple, une mesure de la tension aux bornes d'une résistance d'impédance connue, traversée par le courant à évaluer, constitue une évaluation dudit courant.

Du fait que les volets sont reliés, par l'intermédiaire de charges, à deux lignes électrique distinctes, et du fait qu'au moins deux volets présentent des rapports d'impédances respectifs différents, il sera possible de distinguer ces deux volets lors de la localisation de défaut d'isolation. De manière plus générale, il sera possible de distinguer au moins deux zones du générateur solaire, chaque zone correspondant à des volets présentant le même rapport d'impédances. De préférence, si les rapports d'impédances respectifs des volets du générateur solaire sont tous différents, il sera alors possible de distinguer tous lesdits volets d'un point de vue localisation du défaut d'isolation du générateur solaire.

Dans des modes particuliers de réalisation, le système peut comporter en outre l'une ou plusieurs des caractéristiques suivantes, prises isolément ou selon toutes les combinaisons techniquement possibles.

Dans un mode particulier de réalisation, les cellules solaires de chaque volet étant organisées en chaînes agencées en parallèle, chaque chaîne comportant Ncs cellules solaires agencées en série, la position d'une cellule solaire au sein d'une chaîne étant désignée par « rang » de ladite cellule solaire, ledit système comporte des moyens adaptés à déterminer le rang d'une cellule solaire présentant un défaut d'isolation en fonction notamment des évaluations des courants circulant dans respectivement la première ligne électrique et la seconde ligne électrique.

En effet, un défaut d'isolation entraîne un court-circuit entre la chaîne sur laquelle se trouve le défaut d'isolation et le volet, de sorte que ledit volet est placé au même potentiel électrique que celui de la chaîne à l'endroit dudit défaut d'isolation. Ce potentiel électrique dépend de la position dudit défaut d'isolation sur la chaîne, de sorte qu'il est possible en analysant l'évaluation du courant circulant dans la première ligne électrique ou dans la seconde ligne électrique, de déterminer le rang de la cellule solaire au niveau de laquelle se trouve le défaut d'isolation.

Dans un mode particulier de réalisation, les première charge et seconde charge de chaque volet sont des charges d'un système de protection contre les décharges électrostatiques, la première ligne électrique et la seconde ligne électrique étant des lignes de mise à la masse.

En d'autres termes, les mêmes charges sont utilisées pour la protection contre les décharges électrostatiques et pour localiser les défauts d'isolation. Par rapport à certains systèmes de protection contre les décharges électrostatiques comportant une seule charge et une seule ligne de mise à la masse, une redondance de protection est introduite en reliant les volets à deux lignes de mise à la masse différentes. Par rapport aux systèmes redondants de protection contre les décharges électrostatiques, dans lesquels les volets sont reliés par deux charges identiques à deux lignes de mise à la masse respectives, l'invention ne nécessite, pour localiser le défaut d'isolation sur le générateur solaire, le passage d'aucun câble supplémentaire dans le MEGS.

Dans un mode particulier de réalisation, ledit système comporte des moyens adaptés à filtrer passe-bas les évaluations des courants circulant dans respectivement la première ligne électrique et la seconde ligne électrique.

De telles dispositions sont avantageuses en ce que le courant fourni par un générateur solaire est généralement régulé au moyen d'un hacheur. Un tel hacheur est à l'origine de bruits hautes fréquences (suivant la fréquence de hachage) dans les évaluations de courant, qu'il est avantageux de filtrer passe-bas afin d'améliorer la précision de la détection et de la localisation du défaut d'isolation du générateur solaire.

Dans un mode particulier de réalisation, tous les volets du générateur solaire sont reliés à la même première ligne électrique et à la même seconde ligne électrique.

Selon un second aspect, la présente invention concerne un procédé de détection et de localisation de défaut d'isolation d'un générateur solaire d'engin spatial. selon la revendication 7. Ledit procédé comporte des étapes de :

- détection d'un défaut d'isolation du générateur solaire,
- comparaison des évaluations des courants circulant dans respectivement la première ligne électrique et la seconde ligne électrique,
- localisation du défaut d'isolation sur le générateur solaire, en fonction du résultat de la comparaison.

Dans des modes particuliers de mise en oeuvre, le procédé peut comporter en outre l'une ou plusieurs des caractéristiques suivantes, prises isolément ou selon toutes les combinaisons techniquement possibles.

Dans un mode particulier de mise en oeuvre, l'étape de comparaison comporte le calcul d'un rapport entre les évaluations des courants circulant dans respectivement la première ligne électrique et la seconde ligne électrique.

Dans un mode particulier de mise en oeuvre, les cellules solaires de chaque volet étant organisées en chaînes agencées en parallèle, chaque chaîne comportant Ncs cellules solaires agencées en série, la position d'une cellule solaire au sein d'une chaîne étant désignée par « rang » de ladite cellule solaire, ledit procédé comporte une étape préalable de caractérisation d'une contribution élémentaire de chaque cellule solaire à l'évaluation du courant circulant dans la première ligne électrique ou dans la seconde ligne électrique. Ledit procédé comporte en outre une étape de détermination du rang d'une cellule solaire présentant un défaut d'isolation en fonction de ladite contribution élémentaire et de l'évaluation du courant circulant dans la première ligne électrique ou dans la seconde ligne électrique.

Dans un mode particulier de mise en oeuvre, un défaut d'isolation du générateur solaire est détecté lorsque l'évaluation du courant circulant dans la première ligne électrique ou dans la seconde ligne électrique est supérieure à une valeur seuil prédéfinie.

Selon un troisième aspect, la présente invention concerne un produit programme d'ordinateur selon la revendication 11.

## PRÉSENTATION DES FIGURES

L'invention sera mieux comprise à la lecture de la description suivante, donnée à titre d'exemple nullement limitatif, et faite en se référant aux figures qui représentent :

- Figure 1 : une représentation schématique d'un système de détection et de localisation de défaut d'isolation de générateur solaire d'un satellite en orbite terrestre,
- Figure 2 : une représentation schématique d'un exemple de montage électrique, au niveau d'un générateur solaire, adapté à permettre la détection et la localisation d'un défaut d'isolation,
- Figure 3a : une vue détaillée du générateur solaire de la figure 2, au niveau d'un volet présentant un défaut d'isolation,
- Figure 3b : un schéma électrique équivalent du défaut d'isolation du volet représenté sur la figure 3a,
- Figures 4a, 4b et 4c : des schémas électriques représentant le même schéma électrique que celui de la figure 3b, auquel il a été ajouté des moyens de mesure (figure 4a) ainsi que des schémas électriques équivalents (figures 4b et 4c),
- Figure 5 : un diagramme illustrant les principales étapes d'un exemple de mise en oeuvre de procédé de détection et de localisation de défaut d'isolation d'un générateur solaire.

Dans ces figures, des références identiques d'une figure à une autre désignent des éléments identiques ou analogues. Pour des raisons de clarté, les éléments représentés ne sont pas à l'échelle, sauf mention contraire.

## DESCRIPTION DÉTAILLÉE DE MODES DE RÉALISATION

La présente invention concerne un système de détection et de localisation de défaut d'isolation d'un générateur solaire 20 d'un engin spatial.

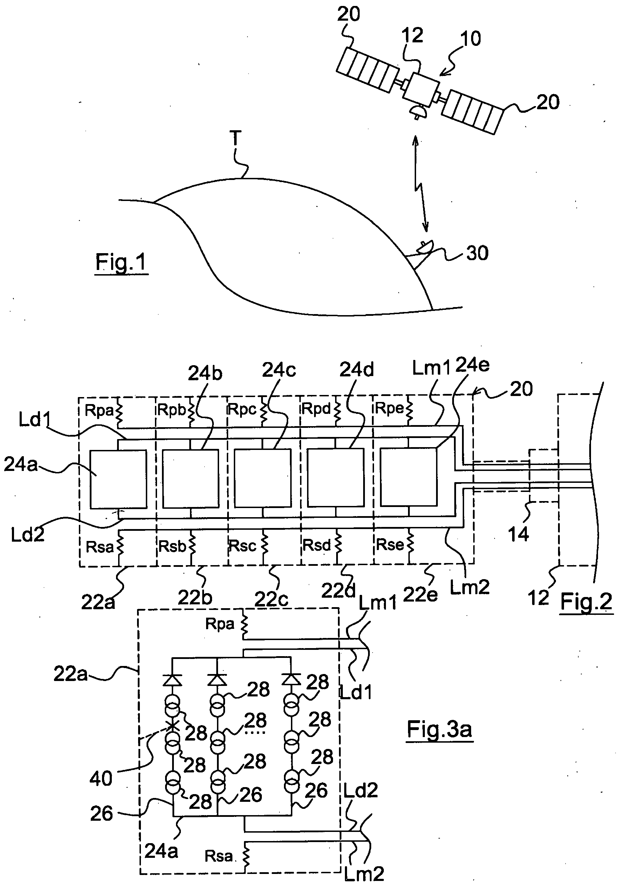

Dans la suite de la description, et tel qu'illustré par la figure 1, on se place de manière non limitative dans le cas où l'engin spatial est un satellite 10 en orbite autour de la Terre T. Rien n'exclut, suivant d'autres exemples, de considérer d'autres types d'engins spatiaux, tels qu'une navette spatiale, un lanceur, etc., pouvant être en orbite ou non autour d'un corps céleste.

Le satellite 10 comporte dans l'exemple représenté un corps 12 et deux générateurs solaires 20 agencés de part et d'autre dudit corps 12. Dans l'exemple illustré par la figure 1, les générateurs solaires 20 sont en outre considérés comme montés mobiles en rotation, au moyen de MEGS 14. Les générateurs solaires 20 comportent des volets qui portent des cellules solaires 28 isolées électriquement desdits volets.

La figure 2 représente de façon très schématique un exemple de montage électrique, au niveau d'un générateur solaire 20, adapté à permettre la détection et la localisation d'un défaut d'isolation dudit générateur solaire.

Le générateur solaire 20 comporte plusieurs volets, par exemple cinq volets dans l'exemple illustré par la figure 2, désignés respectivement par 22a, 22b, 22c, 22d et 22e.

Chaque volet 22a-22e porte une matrice de cellules solaires 28, lesdites matrices étant désignées par respectivement 24a, 24b, 24c, 24d et 24e sur la figure 2. Les matrices 24a-24e sont isolées électriquement des volets 22a-22e, et sont reliées à un réseau de distribution électrique, représenté schématiquement par une première ligne de distribution Ld1 et une seconde ligne de distribution Ld2. La première ligne de distribution Ld1 et la seconde ligne de distribution Ld2 relient les matrices 24a-24e au corps 12 du satellite 10, en passant par exemple à l'intérieur du MEGS 14.

Afin de permettre la détection et la localisation d'un défaut d'isolation du générateur solaire 20, chaque volet 22a-22e est relié, par une première charge Rpa-Rpe, à une première ligne électrique de préférence reliée à la masse, dite « première ligne de mise à la masse » Lm1. Chaque volet 22a-22e est en outre relié, par une seconde charge Rsa-Rse, à une seconde ligne électrique de préférence reliée à la masse, dite « seconde ligne de mise à la masse » Lm2. Dans la suite de la description, on se place de manière non limitative dans le cas où les premières charges Rpa-Rpe et les secondes charges Rsa-Rse sont toutes exclusivement résistives. Par conséquent, les premières charges Rpa-Rpe des volets 22a-22e sont désignées ci-après par « premières résistances » Rpa-Rpe, tandis que les secondes charges Rsa-Rse desdits volets sont désignées ci-après par « secondes résistances » Rsa-Rse.

La première ligne Lm1 de mise à la masse et la seconde ligne Lm2 de mise à la masse relient les volets 22a-22e au corps 12 du satellite 10, en passant par exemple à l'intérieur du MEGS 14.

On comprend que les premières résistances Rpa-Rpe, les secondes résistances Rsa-Rse, la première ligne Lm1 de mise à la masse et la seconde ligne Lm2 de mise à la masse constituent en outre des moyens de protection du générateur solaire 20 contre les décharges électrostatiques. Par conséquent, le système de détection et de localisation de défaut d'isolation peut également être mis en oeuvre, sans modification, comme système de protection du générateur solaire 20 contre les décharges électrostatiques.

Le système de détection et de localisation de défaut d'isolation comporte en outre :

- des moyens adaptés à évaluer des courants circulant dans respectivement la première ligne Lm1 de mise à la masse et la seconde ligne Lm2 de mise à la masse, dits « moyens d'évaluation »,
- des moyens adaptés à détecter et à localiser un défaut d'isolation du générateur solaire 20 en fonction des évaluations desdits courants circulant dans respectivement la première ligne Lm1 de mise à la masse et la seconde ligne Lm2 de mise à la masse, dits « moyens de détection et de localisation ».

Les moyens d'évaluation peuvent prendre toute forme adaptée connue de l'homme de l'art. Par exemple, il est possible de prévoir, sur chacune des première et seconde lignes Lm1, Lm2 de mise à la masse, une résistance d'impédance connue, dite « résistance de mesure » Rm, agencée de sorte à être traversée par le courant circulant dans la ligne de mise à la masse considérée. Ainsi, la tension aux bornes de chacune de ces résistances de mesure Rm est représentative du courant circulant dans respectivement la première ligne Lm1 de mise à la masse et la seconde ligne Lm2 de mise à la masse, et peut être mesurée en mettant en oeuvre tout moyen conventionnel.

Les moyens de détection et de localisation peuvent prendre toute forme adaptée connue de l'homme de l'art. Par exemple, ils peuvent comporter un processeur et une mémoire électronique dans laquelle est mémorisé un produit programme d'ordinateur. Le produit programme d'ordinateur se présente sous la forme d'un ensemble d'instructions de code de programme qui, lorsqu'elles sont exécutées par le processeur, mettent en oeuvre tout ou partie des étapes d'un procédé 50 de détection et de localisation de défaut d'isolation dont un exemple de mise en oeuvre sera décrit en détail ci-après. Dans une variante, lesdits moyens comportent des circuits logiques programmables, de type FPGA, PLD, etc., et/ou des circuits intégrés spécialisés (ASIC), adaptés à mettre en oeuvre tout ou partie des étapes dudit procédé 50 de détection et de localisation de défaut d'isolation.

Dans un mode particulier et nullement limitatif de réalisation, les moyens d'évaluation sont embarqués dans le satellite 10, tandis que les moyens de détection et de localisation sont déportés par rapport au satellite 10, par exemple au niveau d'une station sol (visible sur la figure 1). Dans un tel cas, le satellite 10 comporte des moyens conventionnels d'émission des évaluations desdits courants à destination de la station 30, et ladite station 30 comporte des moyens conventionnels de réception desdits évaluations.

Il est à noter que, dans l'exemple illustré par la figure 2, chaque volet 22a-22e est équipé d'une paire spécifique première résistance Rpa-Rpe / seconde résistance Rsa-Rse. Rien n'exclut, suivant d'autres exemples non illustrés par des figures, d'avoir certaines de ces premières résistances et/ou seconde résistances qui soient partagées entre plusieurs volets 22a-22e.

On désigne par « rapport d'impédances » d'un volet 22a-22e le rapport entre l'impédance de la première résistance Rpa-Rpe et de l'impédance de la seconde résistance Rsa-Rse de ce volet.

Dans un mode préféré de réalisation, les rapports d'impédances respectifs des différents volets 22a-22e sont tous différents entre eux. De telles dispositions permettent de distinguer les volets 22a-22e d'un point de vue localisation de défaut d'isolation. En d'autres termes, de telles dispositions permettent, lorsqu'un défaut d'isolation du générateur solaire 20 a été détecté, de déterminer quel volet 22a-22e présente ledit défaut d'isolation.

La figure 3a représente une vue plus détaillée du générateur solaire 20 de la figure 2, dans le cas en outre où le volet 22a présente un défaut d'isolation (désigné par la référence 40 sur la figure 3a), suite par exemple à une collision avec une météorite.

Dans l'exemple illustré par la figure 3a, les cellules solaires 28 de la matrice 24a du volet 22a sont organisées en chaînes 26 agencées en parallèle, chaque chaîne 26 comportant Ncs cellules solaires 28 agencées en série. Il est à noter que le nombre Ncs de cellules solaires 28 par chaîne 26 peut être différent d'un volet à un autre du générateur solaire 20. A des fins de lisibilité de la figure 3a, le nombre Ncs pour le volet 22a est considéré égal à trois.

On désigne par « rang » d'une cellule solaire 28 la position de ladite cellule solaire dans la chaîne 26 considérée. La première cellule solaire 28 d'une chaîne 26 est donc de rang un, la seconde cellule solaire 28 est de rang deux, la troisième cellule solaire 28 est de rang trois, etc.

Sur la figure 3a, le volet 22a présente un défaut d'isolation entre la cellule solaire 28 de rang deux et la cellule solaire de rang trois. Du fait de ce défaut d'isolation, un court-circuit est établi entre d'une part un point milieu entre la cellule solaire 28 de rang deux et la cellule solaire de rang trois et, d'autre part, le volet 22a. Le volet 22a est donc porté au même potentiel que celui dudit point milieu, correspondant à une tension Vd par rapport à la masse.

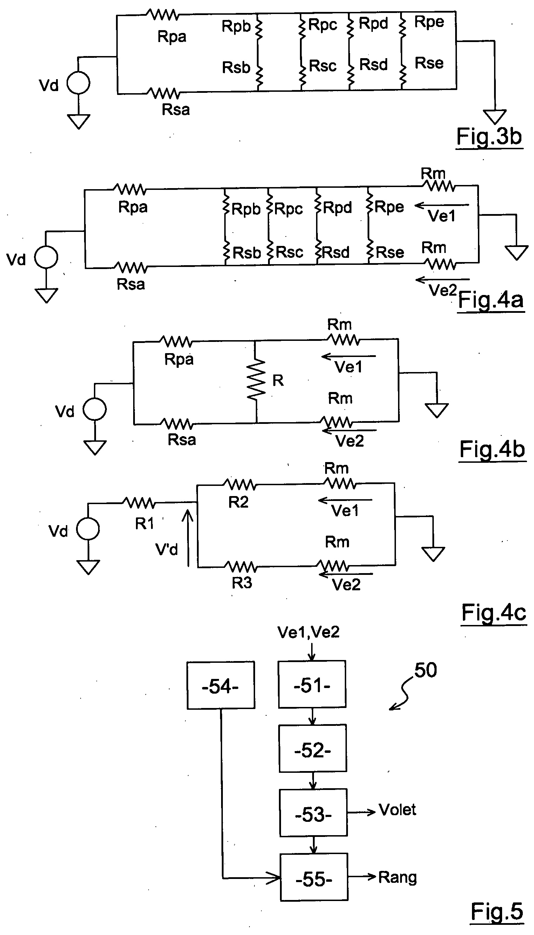

La figure 3b représente un schéma électrique équivalent du défaut d'isolation du volet 22a représenté sur la figure 3a. La figure 3b représente notamment une source de tension Vd, qui est appliquée à la fois à la première ligne Lm1 de mise à la masse et à la seconde ligne Lm2 de mise à la masse, par l'intermédiaire de la première résistance Rpa et de la seconde résistance Rsa. Pour chacun des autres volets 22b-22e, les première et seconde résistances sont représentées en série entre la première ligne Lm1 de mise à la masse et la seconde ligne Lm2 de mise à la masse.

La figure 4a représente le même schéma électrique que celui de la figure 3b, auquel il a été ajouté des moyens de mesure sur chacune des première et seconde lignes Lm1, Lm2 de mise à la masse, en l'occurrence des résistances de mesure Rm considérées comme étant de même impédance.

La tension aux bornes de la résistance de mesure Rm de la première ligne Lm1 de mise à la masse est désignée par Ve1, tandis que la tension aux bornes de la résistance de mesure Rm de la seconde ligne Lm2 de mise à la masse est désignée par Ve2. Il est à noter que, en l'absence de défaut d'isolation, les tensions Ve1 et Ve2 sont théoriquement nulles. Par conséquent, un défaut d'isolation du générateur solaire 20 pourra par exemple être détecté en comparant la tension Ve1 et/ou la tension Ve2 à une valeur seuil prédéfinie.

Les figures 4b et 4c représentent des schémas électriques équivalents de celui de la figure 4a.

Dans la figure 4b, les premières résistances Rpb-Rpe et seconde résistances Rsb-Rse des volets 22b-22e ont été remplacées par leur résistance équivalente R.

La figure 4c représente un schéma équivalent de celui de la figure 4b, dans lequel la première résistance Rpa, la seconde résistance Rsa et la résistance R, montées en triangle, ont été remplacées par le schéma équivalent en étoile, comportant trois résistances R1, R2 et R3. La résistance R2 est agencée en série avec la résistance de mesure Rm de la première ligne Lm1 de mise à la masse, la résistance R3 est agencée en série avec la résistance de mesure Rm de la seconde ligne Lm2 de mise à la masse.

Les valeurs des résistances R1, R2 et R3 sont données par les expressions suivantes :

$$R1 = \frac{Rpa \cdot Rsa}{Rpa + Rsa + R}$$

$$R2 = \frac{Rpa \cdot R}{Rpa + Rsa + R}$$

$$R3 = \frac{Rsa \cdot R}{Rpa + Rsa + R}$$

En désignant par V'd la tension en sortie de la résistance R1, on peut exprimer les tensions Ve1 et Ve2 comme suit :

$$Ve1 = \frac{Rm \cdot V'd}{Rm + R2}$$

$$Ve2 = \frac{Rm \cdot V'd}{Rm + R3}$$

Par conséquent, le rapport entre les tensions Ve1 et Ve2 peut s'exprimer sous la forme suivante :

$$\frac{Ve1}{Ve2} = \frac{Rm + R3}{Rm + R2}$$

On constate par conséquent que le rapport entre les tensions Ve1 et Ve2 dépend des résistances R2 et R3, qui dépendent de la première résistance Rpa et de la seconde résistance Rsa du volet 22a présentant le défaut d'isolation. En particulier, on constate, en fonction des expressions desdites résistances R2 et R3, que des rapports d'impédances différents donnent des rapports différents entre les tensions Ve1 et Ve2. Par conséquent, il sera bien possible, en comparant les tensions Ve1 et Ve2 (qui correspondent aux évaluations des courants circulant dans les première et seconde lignes Lm1, Lm2 de mise à la masse) de distinguer les volets dont les rapports d'impédances sont différents, et donc de localiser le défaut d'isolation préalablement détecté.

Par exemple, les premières résistances Rpa-Rpe et les secondes résistances Rsa-Rse prennent les valeurs suivantes :

|  | Impédance (kΩ) | Rapport d'impédances |
|---|---|---|
| Rpa<br>Rsa | 250<br>50 | 5/1 |
| Rpb<br>Rsb | 150<br>75 | 2/1 |
| Rpc<br>Rsc | 75<br>75 | 1/1 |
| Rpd<br>Rsd | 75<br>150 | 1/2 |
| Rpe<br>Rse | 50<br>250 | 1/5 |

Il est à noter que de telles résistances peuvent être obtenues à partir de résistances déjà mises en oeuvre dans les satellites actuels. Il existe donc déjà des résistances certifiées pour l'environnement spatial qui peuvent être utilisées sans modification et sans certification supplémentaire pour la détection et la localisation de défauts d'isolation d'un générateur solaire 20 de satellite 10.

Dans un mode particulier de réalisation, le système de détection et de localisation de défaut d'isolation comporte des moyens adaptés à filtrer passe-bas les évaluations des courants circulant dans respectivement la première ligne Lm1 de mise à la masse et la seconde ligne Lm2 de mise à la masse, dits « moyens de filtrage passe-bas ». Les moyens de filtrage passe-bas peuvent prendre toute forme adaptée connue de l'homme de l'art. Par exemple, un filtre passe-bas analogique, constitué d'une résistance et d'un condensateur (non représentés sur les figures), peut être inséré sur chacune des première et seconde lignes Lm1, Lm2 de mise à la masse, en amont des résistances de mesure. La fréquence de coupure des moyens de filtrage passe-bas est choisie de sorte à permettre d'atténuer notamment des bruits hautes-fréquences introduits par un hacheur mis en oeuvre pour réguler le courant fourni au satellite 10.

Une fois le volet 22a présentant le défaut d'isolation identifié, il est en outre possible de déterminer le rang de la cellule solaire 28 présentant ledit défaut d'isolation. Par exemple, pour le défaut illustré sur la figure 3a, le volet 22a est porté au même potentiel que celui du point milieu entre la cellule solaire 28 de rang deux et la cellule solaire 28 de rang trois. Ce potentiel dépend du nombre de cellules solaires 28 en amont du défaut d'isolation par rapport au sens de circulation du courant. Ainsi, la tension Vd dépend de la position du défaut d'isolation sur la chaîne 26, et peut par exemple être considérée comme étant sensiblement proportionnelle au nombre de cellules solaires 28 en amont du défaut d'isolation sur la chaîne 26. De même, les tensions Ve1, Ve2 aux bornes des résistances de mesure Rm (évaluations des courants circulant dans les première et seconde lignes Lm1, Lm2 de mise à la masse) peuvent être considérées comme étant sensiblement proportionnelles au nombre de cellules solaires 28 en amont du défaut d'isolation. Ainsi, si la contribution élémentaire de chaque cellule solaire 28 aux tensions Ve1 et Ve2 est connue, il sera possible de déterminer la position du défaut d'isolation sur la chaîne 26.

La figure 5 représente les principales étapes d'un procédé 50 de détection et de localisation d'un défaut d'isolation du générateur solaire 20 du satellite 10, lesquelles sont :

- 51 détection d'un défaut d'isolation du générateur solaire 20,
- 52 comparaison des tensions Ve1 et Ve2 aux bornes des résistances de mesure (évaluations des courants circulant dans les première et seconde lignes Lm1, Lm2 de mise à la masse),
- 53 localisation du défaut d'isolation sur le générateur solaire 20, en fonction du résultat de la comparaison des tensions Ve1 et Ve2.

Au cours de l'étape 51 de détection, on compare par exemple la tension Ve1 et/ou la tension Ve2 à une valeur seuil prédéfinie. Tant quel la tension Ve1 et/ou la tension Ve2 est inférieure à cette valeur seuil prédéfinie, aucun défaut d'isolation n'est détecté. Lorsque la tension Ve1 et/ou la tension Ve2 devient supérieure à cette valeur seuil prédéfinie, le générateur solaire 20 est considéré comme présentant un défaut d'isolation.

Au cours de l'étape 52 de comparaison des tensions Ve1 et Ve2, on calcule par exemple le rapport entre lesdites tensions Ve1 et Ve2. En effet, tel qu'indiqué précédemment, le rapport entre lesdites tensions Ve1 et Ve2 dépend du volet 22a-22e présentant le défaut d'isolation de sorte qu'il permet de déterminer, au cours de l'étape 53 de localisation, quel volet 22a-22e présente le défaut d'isolation préalablement détecté.

Avantageusement, le procédé 50 de détection et de localisation comporte en outre une étape 54 préalable de caractérisation de la contribution élémentaire de chaque cellule solaire 28 à la tension Ve1 et/ou la tension Ve2 aux bornes des résistances de mesure Rm. Une fois le volet présentant le défaut d'isolation identifié au cours de l'étape 53 de localisation, le procédé 50 comporte en outre une étape 55 de détermination du rang de la cellule solaire 28 présentant le défaut d'isolation, en fonction de ladite contribution élémentaire et en fonction de la tension Ve1 et/ou de la tension Ve2 aux bornes des résistances de mesure Rm.

De manière plus générale, il est à noter que les modes de mise en oeuvre et de réalisation considérés ci-dessus ont été décrits à titre d'exemples non limitatifs, et que d'autres variantes sont par conséquent envisageables.

Notamment, l'invention a été décrite en considérant que tous les rapports d'impédances respectifs des volets 22a-22e étaient tous différents. Rien n'exclut, suivant d'autres exemples, d'avoir certains volets 22a-22e présentant des rapports d'impédances identiques, dès lors que les rapports d'impédances d'au moins deux volets 22a-22e sont différents. Par exemple, si l'on ne souhaite distinguer, d'un point de vue localisation de défaut d'isolation, que certaines zones du générateur solaire 20, par exemple une première zone du côté du MEGS 14 et une seconde zone du côté opposé au MEGS 14, il est possible d'organiser les volets 22a-22e en deux groupes, les volets d'un même groupe présentant le même rapport d'impédances, les volets de deux groupes différents présentant des rapports d'impédances différents.

En outre, l'invention a été décrite en considérant que tous les volets 22a-22e du générateur solaire sont reliés à la même première ligne Lm1 de mise à la masse et à la même seconde ligne Lm2 de mise à la masse, ce qui est avantageux d'un point de vue nombre de câbles à faire passer dans le MEGS 14. Rien n'exclut, suivant d'autres exemples, d'avoir plusieurs premières lignes de mise à la masse et/ou plusieurs secondes lignes de mise à la masse. Par exemple, il est possible d'avoir deux premières lignes de mise à la masse et deux secondes lignes de mise à la masse associées respectivement à deux groupes distincts de volets 22a-22e. Dans chacun de ces groupes, les rapports d'impédances des volets sont tous différents. Par contre, il est possible de réutiliser les mêmes rapports d'impédances dans les deux groupes.

## Revendications

1. Système de détection et de localisation de défaut d'isolation d'un générateur solaire (20) d'engin spatial (10), le générateur solaire comportant plusieurs volets (22a-22e), chaque volet portant au moins une cellule solaire reliée à un réseau de distribution électrique et isolée électriquement dudit volet, le système comportant ledit générateur solaire, **caractérisé en ce que** chaque volet est relié, par une première charge et par une seconde charge, à respectivement une première ligne (Lm1) électrique et une seconde ligne (Lm2) électrique et **en ce que**, le rapport entre les impédances de la première charge et de la seconde charge d'un volet (22a-22e) étant désigné par « rapport d'impédances » dudit volet, le générateur solaire (20) comporte au moins deux volets (22a-22e) présentant des rapports d'impédances respectifs différents, ledit système comportant en outre :

   - des moyens pour évaluer des courants circulant dans respectivement la première ligne (Lm1) électrique et la seconde ligne (Lm2) électrique,
   - des moyens pour détecter et à localiser un défaut d'isolation du générateur solaire (20) en fonction des évaluations des courants circulant dans respectivement la première ligne (Lm1) électrique et la seconde ligne (Lm2) électrique.

2. Système selon la revendication 1, **caractérisé en ce que**, les cellules solaires de chaque volet (22a-22e) étant organisées en chaînes agencées en parallèle, chaque chaîne comportant Ncs cellules solaires agencées en série, la position d'une cellule solaire au sein d'une chaîne étant désignée par « rang » de ladite cellule solaire, ledit système comporte des moyens adaptés à déterminer le rang d'une cellule solaire présentant un défaut d'isolation en fonction des évaluations des courants circulant dans respectivement la première ligne (Lm1) électrique et la seconde ligne (Lm2) électrique.

3. Système selon la revendication 1 ou 2, **caractérisé en ce que** les première charge (Rpa-Rpe) et seconde charge (Rsa-Rse) de chaque volet (22a-22e) sont des charges d'un système de protection contre les décharges électrostatiques, la première ligne (Lm1) électrique et la seconde ligne (Lm2) électrique étant des lignes de mise à la masse.

4. Système selon l'une quelconque des revendications précédentes, **caractérisé en ce qu'**il comporte des moyens adaptés à filtrer passe-bas les évaluations des courants circulant dans respectivement la première ligne (Lm1) électrique et la seconde ligne (Lm2) électrique.

5. Système selon l'une quelconque des revendications précédentes, **caractérisé en ce que** les rapports d'impédances respectifs des volets (22a-22e) du générateur solaire (20) sont tous différents.

6. Système selon l'une quelconque des revendications précédentes, **caractérisé en ce que** tous les volets (22a-22e) du générateur solaire sont reliés à la même première ligne (Lm1) électrique et à la même seconde ligne (Lm2) électrique.

7. Procédé (50) de détection et de localisation de défaut d'isolation d'un générateur solaire (20) d'engin spatial (10) au moyen d'un système selon l'une quelconque des revendications précédentes, **caractérisé en ce que** ledit procédé comporte des étapes de :

   - (51) détection d'un défaut d'isolation du générateur solaire (20),
   - (52) comparaison des évaluations des courants circulant dans respectivement la première ligne (Lm1) électrique et la seconde ligne (Lm2) électrique,
   - (53) localisation du défaut d'isolation sur le générateur solaire (20), en fonction du résultat de la comparaison.

8. Procédé (50) selon la revendication 7, **caractérisé en ce que** l'étape (52) de comparaison comporte le calcul d'un rapport entre les évaluations des courants circulant dans respectivement la première ligne (Lm1) électrique et la seconde ligne (Lm2) électrique.

9. Procédé (50) selon l'une des revendications 7 ou 8, **caractérisé en ce que**, les cellules solaires de chaque volet (22a-22e) étant organisées en chaînes agencées en parallèle, chaque chaîne comportant Ncs cellules solaires agencées en série, la position d'une cellule solaire au sein d'une chaîne étant désignée par « rang » de ladite cellule solaire, ledit procédé comporte une étape (54) préalable de caractérisation d'une contribution élémentaire de chaque cellule solaire (28) à l'évaluation du courant circulant dans la première ligne (Lm1) électrique ou dans la seconde ligne (Lm2) électrique, et une étape (55) de détermination du rang d'une cellule solaire présentant un défaut d'isolation en fonction de ladite contribution élémentaire et de l'évaluation du courant circulant dans la première ligne (Lm1) électrique ou dans la seconde ligne (Lm2) électrique.

10. Procédé (50) selon l'une quelconque des revendications 7 à 9, **caractérisé en ce qu'**un défaut d'isolation du générateur solaire (20) est détecté lorsque l'évaluation du courant circulant dans la première ligne (Lm1) électrique ou dans la seconde ligne (Lm2) électrique est supérieure à une valeur seuil prédéfinie.

11. Produit programme d'ordinateur, **caractérisé en ce qu'**il comporte un ensemble d'instructions de code de programme qui, lorsqu'elles sont exécutées par un processeur, mettent en oeuvre un procédé (50) de détection et de localisation d'un défaut d'isolation de générateur solaire (20) d'engin spatial (10) selon l'une quelconque des revendications 7 à 10, ledit processeur fasiant partie du système selon l'une quelconque des revendications 1 à 6.


**Patentansprüche**

1. Vorrichtung zur Erkennung und Lokalisierung eines Isolationsfehlers eines Solargenerators (20) eines Raumfahrzeugs (10), wobei der Solargenerator mehrere Klappen (22a-22e) umfasst, wobei jede Klappe mindestens eine Solarzelle trägt, die mit einem Stromverteilungsnetzwerk verbunden und elektrisch von der Klappe isoliert ist, wobei die Vorrichtung den Solargenerator umfasst, **dadurch gekennzeichnet, dass** jede Klappe durch eine erste Ladung und eine zweite Ladung mit jeweils einer ersten Stromleitung (Lm1) und einer zweiten Stromleitung (Lm2) verbunden ist, und dass, da das Verhältnis zwischen den Impedanzen der ersten Ladung und der zweiten Ladung einer Klappe (22a-22e) "Impedanzenverhältnis" der Klappe genannt wird, der Solargenerator (20) mindestens zwei Klappen (22a-22e) umfasst, die jeweilige unterschiedliche Impedanzenverhältnisse aufweisen, wobei die Vorrichtung außerdem Folgendes umfasst:

- Mittel zum Bewerten der Ströme, die jeweils in der ersten Stromleitung (Lm1) und der zweiten Stromleitung (Lm2) zirkulieren,
- Mittel zur Erkennung und zum Lokalisieren eines Isolationsfehlers des Solargenerators (20) in Abhängigkeit von den Bewertungen der Ströme, die jeweils in der ersten Stromleitung (Lm1) und in der zweiten Stromleitung (Lm2) zirkulieren.

2. Vorrichtung nach Anspruch 1, **dadurch gekennzeichnet, dass** die Solarzellen jeder Klappe (22a-22e) in Ketten geordnet sind, die parallel eingerichtet sind, wobei jede Kette Ncs Solarzellen umfasst, die in Serie eingerichtet sind, wobei die Position einer Solarzelle innerhalb einer Kette "Rang" der Solarzelle genannt wird, wobei die Vorrichtung Mittel umfasst, die angepasst sind, um den Rang einer Solarzelle, die einen Isolationsfehler aufweist, in Abhängigkeit von den Bewertungen der Ströme, die jeweils in der ersten Stromleitung (Lm1) und in der zweiten Stromleitung (Lm2) zirkulieren, zu bestimmen.

3. Vorrichtung nach Anspruch 1 oder 2, **dadurch gekennzeichnet, dass** die erste Ladung (Rpa-Rpe) und die zweite Ladung (Rsa-Rse) jeder Klappe (22a-22e) Ladungen eines Systems zum Schutz vor elektrostatischen Entladungen sind, wobei die erste Stromleitung (Lm1) und die zweite Stromleitung (Lm2) Masseleitungen sind.

4. Vorrichtung nach einem der vorhergehenden Ansprüche, **dadurch gekennzeichnet, dass** sie Mittel umfasst, die angepasst sind, um die Bewertungen der Ströme, die jeweils in der ersten Stromleitung (Lm1) und in der zweiten Stromleitung (Lm2) zirkulieren, zu tiefpassfiltern.

5. Vorrichtung nach einem der vorhergehenden Ansprüche, **dadurch gekennzeichnet, dass** die jeweiligen Impedanzenverhältnisse der Klappen (22a-22e) des Solargenerators (20) alle unterschiedlich sind.

6. Vorrichtung nach einem der vorhergehenden Ansprüche, **dadurch gekennzeichnet, dass** alle Klappen (22a-22e) des Solargenerators mit derselben ersten Stromleitung (Lm1) und mit derselben zweiten Stromleitung (Lm2) verbunden sind.

7. Verfahren (50) zur Erkennung und zur Lokalisierung eines Isolationsfehlers eines Solargenerators (20) eines Raumfahrzeugs (10) mittels einer Vorrichtung nach einem der vorhergehenden Ansprüche, **dadurch gekennzeichnet, dass** das Verfahren die folgenden Schritte umfasst:

   - (51) Erkennung eines Isolationsfehlers des Solargenerators (20),
   - (52) Vergleich der Bewertungen der Ströme, die jeweils in der ersten Stromleitung (Lm1) und der zweiten Stromleitung (Lm2) zirkulieren,
   - (53) Lokalisierung des Isolationsfehlers auf dem Solargenerator (20) in Abhängigkeit von dem Resultat des Vergleichs.

8. Verfahren (50) nach Anspruch 7, **dadurch gekennzeichnet, dass** der Vergleichsschritt (52) die Berechnung eines Verhältnisses zwischen den Bewertungen der Ströme, die jeweils in der ersten Stromleitung (Lm1) und der zweiten Stromleitung (Lm2) zirkulieren, umfasst.

9. Verfahren (50) nach einem der Ansprüche 7 oder 8, **dadurch gekennzeichnet, dass** die Solarzellen jeder Klappe (22a-22e) in Ketten geordnet sind, die parallel eingerichtet sind, wobei jede Kette Ncs Solarzellen umfasst, die in Serie eingerichtet sind, wobei die Position einer Solarzelle innerhalb einer Kette "Rang" der Solarzelle genannt wird, wobei das Verfahren einen vorausgehenden Charakterisierungsschritt (54) eines elementaren Beitrags jeder Solarzelle (28) zur Bewertung des Stroms, der in der ersten Stromleitung (Lm1) oder in der zweiten Stromleitung (Lm2) zirkuliert, und einen Bestimmungsschritt (55) des Rangs einer Solarzelle, die einen Isolationsfehler aufweist, in Abhängigkeit von dem elementaren Beitrag und der Bewertung des Stroms, der in der ersten Stromleitung (Lm1) oder in der zweiten Stromleitung (Lm2) zirkuliert, umfasst.

10. Verfahren (50) nach einem der Ansprüche 7 bis 9, **dadurch gekennzeichnet, dass** ein Isolationsfehler des Solargenerators (20) erkannt wird, wenn die Bewertung des Stroms, der in der ersten Stromleitung (Lm1) oder in der zweiten Stromleitung (Lm2) zirkuliert, größer ist als ein vordefinierter Schwellenwert.

11. Computerprogrammprodukt, **dadurch gekennzeichnet, dass** es eine Einheit von Programmcodeanweisungen umfasst, die, wenn sie von einem Prozessor ausgeführt werden, ein Verfahren (50) zur Erkennung und Lokalisierung eines Isolationsfehlers eines Solargenerators (20) eines Raumfahrzeugs (10) nach einem der Ansprüche 7 bis 10 umsetzen, wobei der Prozessor zu der Vorrichtung nach einem der Ansprüche 1 bis 6 gehört.

**Claims**

1. System for detecting and locating an insulation flaw in a solar generator (20) on a spacecraft (10), the solar generator comprising a plurality of flaps (22a-22e), each flap bearing at least one solar cell that is connected to an electrical distribution network and electrically insulated from said flap, the system comprising said solar generator, **characterized in that** each flap is connected, by a first load and by a second load, to a first electrical line (Lm1) and a second electrical line (Lm2), respectively, and **in that**, the ratio of the impedances of the first load and of the second load of a flap (22a-22e) being denoted by "impedance ratio" of said flap, the solar generator (20) comprises at least two flaps (22a-22e) exhibiting different respective impedance ratios, said system furthermore comprising:

   - means for evaluating currents flowing in the first electrical line (Lm1) and the second electrical line (Lm2), respectively,
   - means for detecting and locating an insulation flaw in the solar generator (20) on the basis of the evaluations of the currents flowing in the first electrical line (Lm1) and the second electrical line (Lm2), respectively.

2. System according to claim 1, **characterized in that**, the solar cells of each flap (22a-22e) being organized into strings arranged in parallel, each string comprising Ncs solar cells arranged in series, the position of a solar cell within a string being denoted by the "rank" of said solar cell, said system comprises means adapted to determining the rank of a solar cell exhibiting an insulation flaw on the basis of the evaluations of the currents flowing in the first electrical line (Lm1) and the second electrical line (Lm2), respectively.

3. System according to claim 1 or 2, **characterized in that** the first load (Rpa-Rpe) and the second load (Rsa-Rse) of each flap (22a-22e) are loads of a system for protecting against electrostatic discharges, the first electrical line (Lm1) and the second electrical line (Lm2) being grounding lines.

4. System according to any of the preceding claims, **characterized in that** it comprises means adapted to low-pass filtering the evaluations of the currents flowing in the first electrical line (Lm1) and the second electrical line (Lm2), respectively.

5. System according to any of the preceding claims, **characterized in that** the respective impedance ratios of the flaps **(22a-22e)** of the solar generator (20) are all different.

6. System according to any of the preceding claims, **characterized in that** all the flaps (22a-22e) of the solar generator are connected to the same first electrical line (Lm1) and to the same second electrical line (Lm2).

7. Method (50) for detecting and locating an insulation flaw in a solar generator (20) on a spacecraft (10) by using a system according to any of the preceding claims, **characterized in that** said method comprises steps of:

   - (51) detecting an insulation flaw in a solar generator (20),
   - (52) comparing the evaluations of the currents flowing in the first electrical line (Lm1) and the second electrical line (Lm2), respectively,
   - (53) locating the insulation flaw on the solar generator (20) on the basis of the result of the comparison.

8. Method (50) according to claim 7, **characterized in that** the comparison step (52) comprises the calculation of a ratio for the evaluations of the currents flowing in the first electrical line (Lm1) and the second electrical line (Lm2), respectively.

9. Method (50) according to claim 7 or 8, **characterized in that**, the solar cells of each flap (22a-22e) being organized into strings arranged in parallel, each string comprising Ncs solar cells arranged in series, the position of a solar cell within a string being denoted by the "rank" of said solar cell, said method comprises a prior step (54) of characterizating an unitary contribution by each solar cell (28) to the evaluation of the current flowing in the first electrical line (Lm1) or in the second electrical line (Lm2), and a step (55) of determining the rank of a solar cell exhibiting an insulation flaw on the basis of said unitary contribution and of the evaluation of the current flowing in the first electrical line (Lm1) or in the second electrical line (Lm2).

**10.** Method (50) according to any of claims 7 to 9, **characterized in that** an insulation flaw in the solar generator (20) is detected when the evaluation of the current flowing in the first electrical line (Lm1) or in the second electrical line (Lm2) is higher than a predefined threshold value.

**11.** Computer program product, **characterized in that** it comprises a set of program code instructions that, when executed by a processor, implement a method (50) for detecting and locating an insulation flaw in a solar generator (20) on a spacecraft (10) according to any of claims 7 to 10, said processor belonging to a system according to any of claims 1 to 6.

Fig.1

Fig.2

Fig.3a

Fig.3b

Fig.4a

Fig.4b

Fig.4c

Fig.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012100263 A
- DE 102011007222 A
- EP 1265076 A